# EUROPEAN PATENT SPECIFICATION

(11) **EP 4 318 828 B1**
(45) Date of publication and mention of the grant of the patent: **14.01.2026**
(21) Application number: 23461571.4
(22) Date of filing: 28.04.2023
(51) Int. Cl.: H01S 3/13, H01S 3/00, H01S 3/23, H01S 5/00, H01S 5/0687, H01S 5/40

(54) **A SYSTEM AND A METHOD FOR STABILISING NIR-VIS LASER TO ANY FREQUENCY USING CAVITY TRANSFER LOCK TO FREQUENCY SHIFTED C-BAND STABLE LASER**
SYSTEM UND VERFAHREN ZUR STABILISIERUNG EINES NIR-VIS-LASERS AUF BELIEBIGE FREQUENZEN UNTER VERWENDUNG EINES RESONATORS ZU EINEM FREQUENZVERSCHOBENEN C-BAND-STABILEN LASER
SYSTÈME ET PROCÉDÉ DE STABILISATION D'UN LASER NIR-VIS À UNE FRÉQUENCE QUELCONQUE À L'AIDE D'UN VERROUILLAGE DE TRANSFERT DE CAVITÉ À UN LASER STABLE EN BANDE C DÉCALÉ EN FRÉQUENCE

(43) Date of publication of application: 07.02.2024
(73) Proprietor: Uniwersytet Warszawski, 00-927 Warszawa (PL)
(72) Inventor: Wasilewski, Wojciech, 02-130 Warszawa (PL); Mazelanik, Mateusz, 01-431 Warszawa (PL); Parniak - Niedojadlo, Michal, 03-976 Warszawa (PL); Tanska, Lidia, 01-461 Warszawa (PL); Koziarska - Glinka, Bozena, 02-776 Warszawa (PL); Borowka, Sebastian, 00-231 Warszawa (PL)
(74) Representative: AOMB Polska Sp. z.o.o.

(56) References cited:
- EP-A1- 3 940 898
- US-A1- 2019 181 611
- LIANG WEI ET AL: "Stabilizing the microresonator frequency comb", 2016 IEEE PHOTONICS CONFERENCE (IPC), IEEE, 2 October 2016 (2016-10-02), pages 354 - 355, XP033050806, DOI: 10.1109/IPCON.2016.7831134

## Description

### Technical field

The subject matter of the invention is a system for stabilising near infrared - visible (NIR-VIS) laser light to any frequency using cavity transfer lock to frequency shifted C-band stable laser, that refers to the wavelength range 1530-1565 nm, typically used in optical telecommunications.

### Prior art

In the prior art patent document filed in 1981 [US4468773A] describes a method and system for stabilising the light frequency of a laser, that comprises a laser control apparatus for use with a laser having output radiation including an intermodal beat frequency and electric signal responsive means for controlling the light frequency from the laser. Radiation responsive electric signal means adapted for association with said radiation for providing an electric signal having a frequency as a function of said beat frequency; and means for sensing changes in phase of the aforementioned signal and providing a second electric signal varying as a function thereof and being adapted for connection to the electric signal responsive means. The apparatus also includes a phase comparator and circuitry providing a phase lock of the first-named and reference signals.

Another prior art patent document filed in 2008 [US7970025B2] describes an alternative method and a system for stabilising a laser to a frequency reference with an adjustable offset. The method locks a sideband signal generated by passing an incoming laser beam through the phase modulator to a frequency reference, and adjusts a carrier frequency relative to the locked sideband signal by changing a phase modulation frequency input to the phase modulator. The sideband signal can be a single sideband (SSB), dual sideband (DSB), or an electronic sideband (ESB) signal. Two separate electro-optic modulators can produce the dual sideband (DSB) signal. The two electro-optical modulators can be a broadband modulator and a resonant modulator. With a dual sideband (DSB) signal, the method can introduce two sinusoidal phase modulations at the phase modulator.

In 2017 it was published that B. Rauf et al. ['Multiple wavelength stabilisation on a single optical cavity using the offset sideband locking technique', Opt. Lett. 42, 1970-1973 (2017), https://doi.org/10.1364/OL.42.001970] where it as implemented a compact, robust, and stable device for simultaneous frequency stabilisation of lasers with different wavelengths used for the cooling and trapping of ytterbium atoms (Yb) in an optical lattice clock. The lasers at 399, 556, and 759 nm are locked to a single ultra-stable cavity using the offset sideband locking technique, a modified version of the Pound-Drever-Hall (PDH) method. For the most demanding stabilisation here, the 556 nm laser, this system exhibits a 300 Hz linewidth for an integration time of 80 ms. A long-term drift of less than 20 kHz per day was observed at 759 nm that is suitable for operating the lattice laser with a light shift uncertainty below 1 × 10⁻¹⁸. The system kept operating the clock during a typical working day by simultaneously locking the three lasers to the cavity.

In 2017 scientific publication [Jiandong Bai, Jieying Wang, Jun He, Junmin Wang 'Electronic sideband locking of a broadly tunable 318.6 nm ultraviolet laser to an ultra-stable optical cavity' J. Opt. 19 (2017) 045501 (6 pp); https://doi.org/10.1088/2040-8986/aa5a8c] describes frequency stabilisation of a tunable 318.6 nm ultraviolet (UV) laser system using electronic sideband locking. By indirectly changing the frequency of a broadband electro-optic phase modulator, the laser can be continuously tuned over 4 GHz, while a 637.2 nm laser is directly stabilised to a high-finesse ultra-stable optical cavity. The doubling cavity also remains locked to the 637.2 nm light. The tuning range depends mainly on the gain-flattening region of the modulator and the piezo-tunable range of the seed laser. The frequency-stabilised tunable UV laser system is able to compensate for the offset between reference and target frequencies, and has potential applications in precision spectroscopy of cold atoms.

In 2017 Jack C. Sankey et al. published ['Simple delay-limited sideband locking with heterodyne readout' Opt. Express 25, 1582-1597 (2017); https://doi.org/10.1364/OE.25.001582]. A robust sideband laser locking technique ideally suited for applications requiring low probe power and heterodyne readout was presented. By feeding back to a high-bandwidth voltage-controlled oscillator, a first-order phase-modulation sideband was locked to a high-finesse Fabry-Perot cavity in ambient conditions, achieving a closed-loop bandwidth of 3.5 MHz (with a single integrator - chip) limited fundamentally by the signal delay. The measured transfer function of the closed loop agrees with a simple model based on ideal system components, and from this we suggest a modified design that should achieve a bandwidth exceeding 6 MHz with a near-causally limited feedback gain as high as 4 x 10⁷ at 1 kHz. The off-resonance optical carrier enables alignment-free heterodyne readout, alleviating the need for additional lasers or optical modulators.

In 2019 S. Subhankar published ['Microcontroller based scanning transfer cavity lock for long-term laser frequency stabilization' Rev. Sci. Instrum. 90, 043115 (2019); doi: 10.1063/1.5067266] A compact all-digital implementation of a scanning transfer cavity lock (STCL) for long-term laser frequency stabilisation was presented. An interrupt-driven state machine is employed to realise the STCL with the capability to correct for frequency drifts in the slave laser frequency due to measured changes in the lab environmental conditions. We demonstrate an accuracy of 0.9 MHz for master laser and slave laser wavelengths of 556 nm and 798 nm as an example. The slave laser is also demonstrated to dynamically scan over a wide frequency range while retaining its lock, allowing us to accurately interrogate atomic transitions.

In 2001 Eric D. Black involved in a LIGO project published ['An introduction to Pound-Drever-Hall laser frequency stabilization' American Journal of Physics 69, 79 (2001); https://doi.org/10.1119/1.1286663]. This publication discusses in depth the working of Pound-Drever-Hall laser frequency stabilisation mechanism, enabling design of a real setup, suitable for research or industrial application.

The prior art patent document filed in 2020 [EP 3 940 898 A1] discloses embodiments for stabilizing simultaneously N lasers using an optical resonator. A distance between two mirrors forming the optical resonator is adjusted to a stabilization length. More specifically, at the stabilization length, there is, for each of N respective mutually different predetermined frequencies, a resonant frequency of the optical resonator for which the difference between the predetermined frequency and the said resonant frequency is smaller than a predetermined target value. Light from each of the N lasers is fed to the optical resonator and, thereby, N respective error signals are generated. Based on the N error signals, the N lasers are stabilized simultaneously.

In 2016 Wei Liang at al. publisher article "Stabilizing the Microresonator Frequency Comb", 2016 IEEE PHOTONICS CONFERENCE (IPC) (DOI:10.1109/ipcon.2016.7831134) disclosing stabilization of the Kerr frequency comb oscillators including stabilization of the devices operating within the telecommunication frequency band by means of miniature atomic frequency reference cells. A frequency comb centered at 1560 nm wavelength locked simultaneously to both D1 and D2 lines of Rubidium using optical frequency doublers and 33 GHz microwave signal was disclosed. Allan deviation on the order of 10-9 [3]. Paper discloses the improvement that was achieved using a high-Q magnesium fluoride (MgF2) crystalline whispering gallery mode (WGM) resonator to produce the frequency comb.

The prior art patent document filed in 2018 [US20190181611A1] discloses a two-point locking system for stabilizing a frequency comb oscillator using at least two optical transitions of the same atomic/molecular sample. In an example, an optical reference sample is provided that is characterized by two or more optical transitions. A coherent light source provides polychromatic coherent light (such as an optical frequency comb). The beams of light, occupying the same spatial mode volume or separated in space, and having frequencies in the vicinity of the optical transitions of the reference sample, interrogate the resonances of the reference sample. Interrogation signals obtained using phase/frequency/amplitude spectroscopy or other spectroscopy techniques are then used to stabilize the frequency harmonics of the light. If the harmonics belong to the same coherent frequency comb, the entire comb becomes stabilized using this procedure. In an illustrative example, a stable atomic optical clock is provided using these techniques.

### Problem from the state of the art

The problem from the prior art is to provide a reliable, and fast stabilisation of laser light in a range of near infrared - visible (NIR-VIS) to any frequency. In comparison to prior art the presented system simultaneously enables referencing to widely available standards, and electronic programming of arbitrary frequency offset, while being less complicated than optical frequency comb.

Known systems in prior art involve use of stabilised frequency comb. The slave laser is stabilised to any tooth of the comb with electronically adjustable offset *(i.e.* beat frequency). The comb is stabilised either to a hydrogen maser or to master laser which is in turn stabilised to very stable cavity and ultranarrow atomic resonance. Such systems provide best stability at large cost, mass and volume.

Multitude of simpler systems for stabilising lasers are known in prior art, based on some form of cavities (*e.g.* etalons), atomic resonances, *etc.* However cavities lack inherent long term stability while atomic resonances occur only at some sparse frequencies.

Various forms of transfer locks are known prior at, in which two resonances of the same physical cavity at two distinct wavelengths are probed simultaneously. Existing arrangements enable fixing frequencies of multiple lasers to resonances of the same cavity.

However, a solution enabling continuous tuning of slave laser over multiple free spectral ranges of the cavity and providing means for repetitive stabilisation of said cavity to the same length with commercially available components is missing.

### Solution to the problem

The invention described in the present patent document relates to the problem of absolute frequency stabilisation of a tunable laser. In particular, numerous applications of atomic quantum technologies rely on manipulation of the internal state of atoms and molecules. This requires light of precisely controlled frequency (sub-MHz) with respect to atomic transitions, which occur at fundamentally fixed frequencies. The solution presented enables transferring the stability from widely available telecommunication lasers onto a very wide range of optical frequencies. For any laser operating at a wavelength in range 400-1400 nm, called slave laser, the solution enables transferring absolute frequency stability from said reference laser, called master, to the slave. The inventive solution also enables adjusting the frequency of slave laser in a continuous fashion or in few-MHz steps by many GHz under digital control without any action directly on the master laser.

### Glossary and definitions of terms known in the state of the art and used in the patent specification

In the present specification, the terms used have the following meanings described in the definitions below:
The term "master laser" means a single-frequency laser stabilised to absolute frequency reference.

The term "slave laser" means a tunable laser to be stabilised.

The term "PDH servo" means a control system for the Pound-Drever-Hall (PDH) technique that is a widely used and powerful approach for stabilising the frequency of light emitted by a laser by means of locking to a stable cavity. The PDH technique has a broad range of applications including interferometric gravitational wave detectors, atomic physics, and time measurement standards, many of which also use related techniques such as frequency modulation spectroscopy.

The term "servo" means electronic control system used for stabilisation. The servo system is fed with the so-called error signal. The error signal informs about the deviation of the current laser frequency from the set frequency. The servo system drives the laser so as to minimise the error signal. Typical examples include PI (proportional + integral) servo.

The term "FPGA" means a Field-Programmable Gate Array (FPGA), that is an integrated circuit (chip) designed to be configured by a customer or a designer after manufacturing - hence the term field-programmable. The FPGA configuration is generally specified using a hardware description language (HDL), similar to that used for an application-specific integrated circuit - chip (ASIC). Circuit diagrams were previously used to specify the configuration, but this is increasingly rare due to the advent of electronic design automation tools.

The term "dither" means small periodic modulation of beam frequency around its mean frequency. Dithering enables fast probing of the response of the atoms or cavity to small frequency changes, in particular it enables establishing if the beam frequency is above or below the resonance frequency and by how much, thus enabling computation of error signal.

The term "VCO" means a Voltage-Controlled Oscillator (VCO), that is an electronic oscillator whose oscillation frequency is controlled by a voltage input. The applied input voltage determines the instantaneous oscillation frequency.

The term "PLL" means Phase-Locked Loop (PLL), and is a control system that stabilises the phase of a VCO to a multiple of reference signal. Modern PLL enables multiplication by a rational number.

The term "PBS" for the purpose of describing the present invention means Polarising Beam Splitter.

The term "FSR" stands for Free Spectral Range (FSR), that is the spacing in optical frequency or wavelength between two successive reflected or transmitted optical intensity maxima or minima of an interferometer.

The term "QWP" stands for Quarter-Wave Plate (QWP), after passing through which light can change its polarisation. On a path equal to the thickness of the plate, light with the fast-axis direction of polarisation overtakes light with the slow-axis direction of polarisation by a quarter of a wavelength.

The term "HWP" stands for Half Wave Plate, that means an optical element made up of a layer of birefringent material, which allows a transformation of light polarisation for a fixed range of light wavelengths. In particular, for linear polarisation, depending on the position of the element with respect to the direction of polarisation of light, the polarisation direction can be rotated by a selected angle. A frequently used position of the element rotates H polarisation to V polarisation, and vice versa, V polarisation to H polarisation.

The term "NIR-VIS" means a range of light frequencies from near infrared to visible.

The term "Light power" is the energy carried by a laser beam per unit time whereas "light intensity" is light power per unit area. For a fixed beam size the parameters are proportional to one another.

The term "C-band laser" refers to infrared optical communications, C-band (C for "conventional") using the wavelength range 1530-1565 nm, which corresponds to the amplification range of erbium doped fibre amplifiers.

In the present document, other terms not defined above have meanings which are given and understood by a professional in the field in light of the best knowledge available, the present disclosure and the context of the patent specification.

### Summary of the invention

The scope of the present invention is defined by the independent claims. Preferred embodiments are defined in the dependent claims.

An invention relates to a system for stabilising NIR-VIS laser to any frequency using cavity transfer lock to frequency shifted C-band stable laser, comprising:
a master laser, configured for emitting a master light beam towards a sampling plate, the sampling plate configured for splitting the master light beam into two light beam portions
   and for directing a first portion of said master light beam through a sampling plate and a polarising beam splitter, PBS, and a quarter-wave plate, QWP, to an optical cavity, which optical cavity is configured for directing the first portion of the master light beam reflected therefrom back through the quarter wave plate and the polarising beam splitter towards a photodiode, which photodiode is configured for providing an electrical signal to a first PDH servo for cavity stabilisation to the master laser, wherein
   the first PDH servo is electrically connected with the cavity and
the cavity is configured for receiving a slave light beam from a slave laser, through a polarising beam splitter, PBS, and a quarter-wave plate, QWP, and for directing the slave light beam reflected therefrom back through the quarter wave plate and the polarising beam splitter towards a photodiode, which photodiode is configured for providing an electrical signal to a second PDH servo for slave laser stabilisation to the cavity,
   and for directing a second portion of said master light beam via light pathway to frequency shift and dither subsystem, comprising a reference light beam modulator and then through an atomic reference to a reference photodiode detector with demodulator, which is configured for providing a reference intensity electric signal to the master laser,
wherein the system further comprises:
   - a fibre (11) and a fibre electro-optical phase modulator (12) and is configured for providing the master laser beam through the fibre (11) to the phase modulator (12) and further to the sampling plate (54a) and
   - a voltage-controlled oscillator, VCO, of phase-locked loop, PLL, which is dithered by PDH reference oscillator at frequency from 1 MHz to 100 MHz which imposes phase modulation for PDH scheme,
wherein the modulator (12) of master laser (10) is stabilised with at least 0.3 GHz to 4 GHz bandwidth
   and wherein the first PDH servo (6a) is electrically connected (80) to the slave laser (60) such way to provide electric fast feed forward signal of the first PDH servo (6a) to the slave laser (60), wherein the slave laser is configured to be modulated significantly faster by the fast feed-forward signal than the electrical signal for cavity stabilisation in order to compensate for cavity length noise at high frequencies.

Normally this intensity is constant, especially the sidebands frequency δ_{MP}, but for some types of modulators a parasitic amplitude modulation might appear. Its otherwise disruptive effects can be cancelled by measuring said amplitude modulation and subtracting it from signal proper at later stage.

Preferably, the cavity possesses a finesse F greater than 200 in respect for both the master laser and the slave laser.

Preferably, the master laser is a narrow linewidth laser, having the linewidth of less than 100 kHz, preferably a C-band laser, and having a long term frequency stabilised, preferably to atomic reference, preferably its second harmonic locked to Rubidium transition.

Preferably, the slave laser is electronically tunable at least by 2 GHz within a minimum time of 1 ms.

Preferably, electronic signal for the optical modulator is generated by a phase-locked loop together with a voltage controlled oscillator PLL+VCO, is an integrated circuit.

The invention relates also to a method of stabilising a NIR-VIS laser to any frequency using cavity transfer lock to frequency shifted C-band stable laser, performed in a system defined above, the method comprising the following actions:
(a) locking master laser with a sideband signal generated by passing an incoming laser beam emitted by a master laser through the reference light beam modulator to the atomic reference;
(b) adjusting an electronic sideband frequency relative to the locked master laser frequency by changing frequency shift with the phase modulator - scanning cavity and observing master laser electronic sideband resonance in the cavity;
(c) locking the cavity to the master laser electronic sideband shifted to the resonance of the cavity;
(d) locking slave laser to the resonance of the cavity with a signal generated by passing an incoming laser beam emitted by a slave laser through a phase modulator, wherein the first PDH servo is electrically connected to the slave laser in such a way as to provide electric fast feed forward signal of the first PDH servo (6a) to the slave laser (60), and wherein the slave laser is modulated significantly faster by the electric fast feed forward signal than the electrical signal for cavity stabilisation in order to compensate for cavity length noise at high frequencies.

Preferably, a first PDH servo stabilises the optical cavity in order to control +1 or -1 electronic sideband of the master laser generated by the optical modulator.

Preferably, the light beam from the master laser is directed via a light pathway into the fibre and the phase modulator that is driven by a frequency modulated tunable radio frequency signal from the first PDH servo and then the light beam is directed by a light pathway to a collimator and through the sampling plates, the polarising beam splitter and the quarter wave plate enters the optical cavity.

Preferably, the part of the master laser beam reflected from the optical cavity goes through the quarter wave plate a second time and is reflected by the polarising beam splitter towards the photodiode, which converts the intensity of reflected light into electrical signal.

Preferably, the length of the optical cavity is adjusted electronically by at least 2 wavelengths of the master laser by means of a piezo transducer or other means, such as thermal control of an invar body of the cavity.

The invention relates also to a computer program, characterized in that it contains instructions which implement the above method and includes instructions which, once uploaded to the integrated circuit of the phase-locked loop and voltage controlled oscillator module, implements the method defined above.

### Advantageous effects of the invention

The invention according to the present patent specification has numerous advantages.

The invention allows for fine tuning the centre frequency without sacrificing the in-band noise performance of the stabilisation system. The disclosure includes a class of techniques to stabilise a laser frequency to a fixed optical cavity resonance with an adjustable offset. This approach can provide a wide tuning range for the central frequency. These techniques have the advantage of not altering the intrinsic stability of the frequency reference. These sideband techniques can perform comparably to the standard, non-tunable Pound-Drever-Hall technique, each providing more than four decades of frequency noise suppression over the free-running noise.

### Possible areas of application of the invention

The present invention finds a use in the optical communications as well as in the telecommunications, satellite and industry.

### Preferred embodiments of the invention

Now, the invention will be presented in more detail, in a preferred embodiment, with reference to the attached drawing in which:

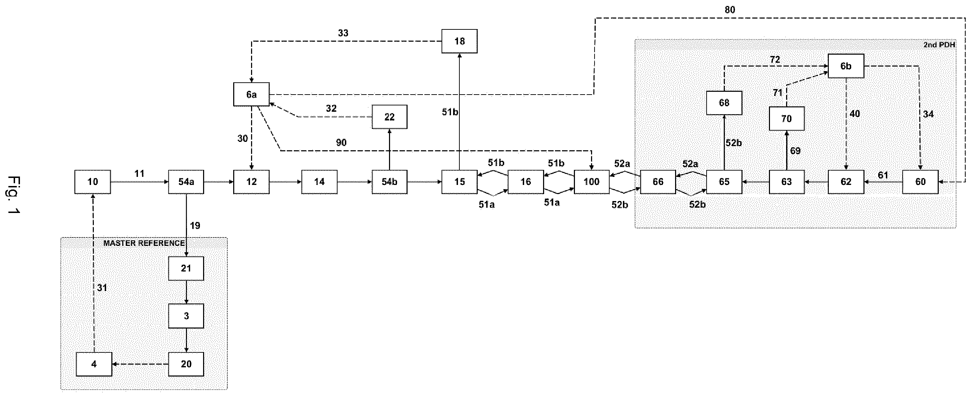

- Fig. 1: depicts a detailed overall block diagram, comprising a main body of an embodiment of the present invention (including two PDH servos), as well as fast feed forward, and a master reference. It depicts: 10 - master reference laser; 11 - fibre; 12 - phase modulator; 54a/54b - sampling plates; 14 - collimator; 22 - detector; 15 - PBS; 16 - QWP; 100 - optical cavity; 18 - photodiode (detector), 19 - a small portion of the modulated light beam; 20 - reference photodiode (detector); 21 - reference light beam modulator; 3 - atomic reference; 4 - demodulator (servo - electronic circuit providing stabilisation feedback for master laser 10); 30 - master frequency shift and PDH modulation signal (electric signal); 31 - reference intensity electric signal, 32 - reference intensity of master laser (electric signal); 33 - slave frequency shift and PDH modulation signal (electric signal); 6a - first PDH servo (for cavity stabilisation to master laser); 6b - second PDH servo for stabilisation of slave laser to cavity; 60 - slave laser; 61 - light beam of a slave laser; 62 - phase modulator; 40 - slave PDH modulation electric signal; 63 - sampling plate; 65 - PBS; 66 - QWP; 51a - incoming light beam from the master laser 10 to the optical cavity 100; 51b - light beam reflected from the optical cavity 100; 52a - incoming light beam from the slave laser 60 to the optical cavity100; 52b - light beam reflected from the optical cavity 100; 68 - photodiode; 69 - reference light beam of the slave laser 60; 70 - reference photodiode; 71 - electric signal of reference intensity slave laser; 72 - electric signal of reflected intensity light beam for second PDH; 80 -electric fast feed forward signal of the first PDH servo 6a to the slave laser 60; 90 - electrical master laser error signal used to correct the length of the optical cavity 100. For clarity's sake: dash lines means electrical cable connections, whereas a solid continuous line means a light beam pathway.

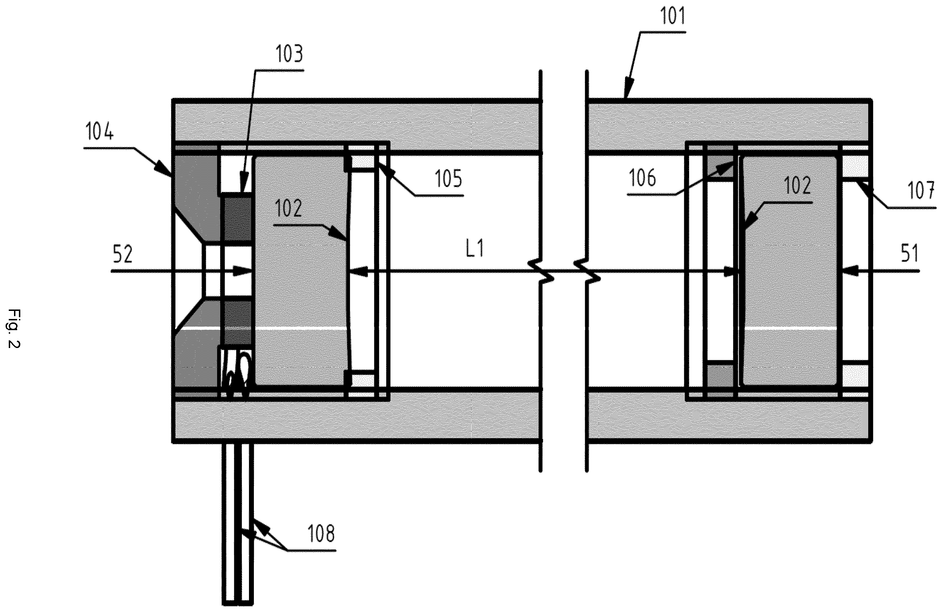

- Fig. 2: depicts an example of the optical cavity 100, that comprises: cavity body 101 (made of invar or aluminium), two high-reflectance concave mirrors 102 that are facing each other concave inside a cavity body 101; piezo transducer 103 to adjust L1 distance between mirrors 102 by more than two master laser wavelengths, 51 - light path of reference the master laser 10; 52 - light path of the slave laser 60; 104 and 106 - rigid supports for mirrors, *such* as brass, aluminium alloys; 105 and 107 - softer supports for mirrors, *such* as rubber, or Teflon, 108 - support of the cavity 100; L1 - distance between the mirrors 102 inside the cavity 100.
- Fig. 3: depicts a block diagram of controller for master laser 10 modulation and Pound-Drever-Hall (PDH) cavity lock.
- Fig. 4: depicts a detailed block diagram controller of a slave laser 60 locking and a second Pound-Drever-Hall (PDH) cavity lock.

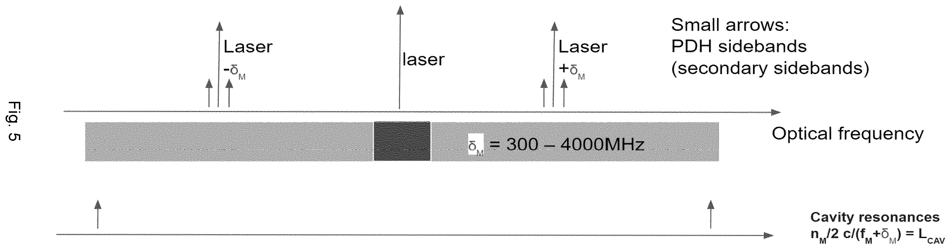

- Fig. 5: depicts an optical frequency diagram of master laser spectrum after modulator

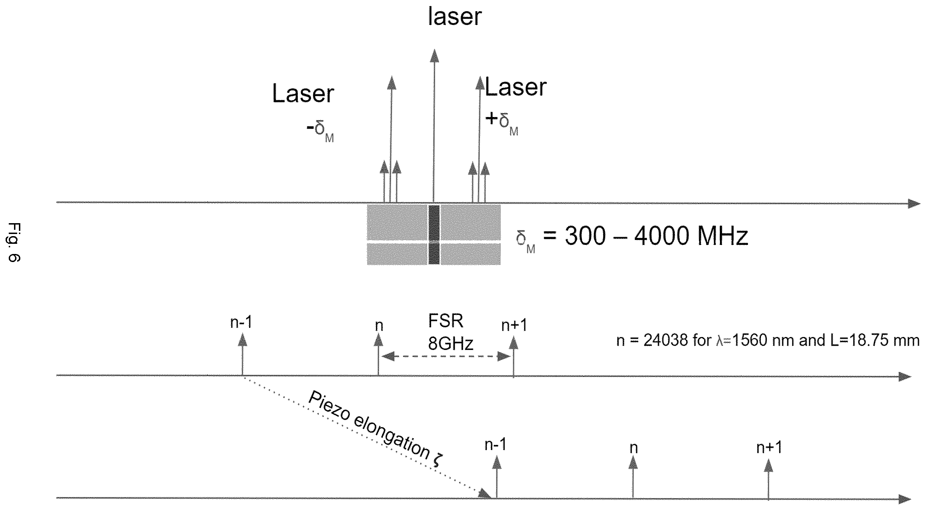

- Fig. 6: depicts a view of the master-laser spectrum diagram after modulation.

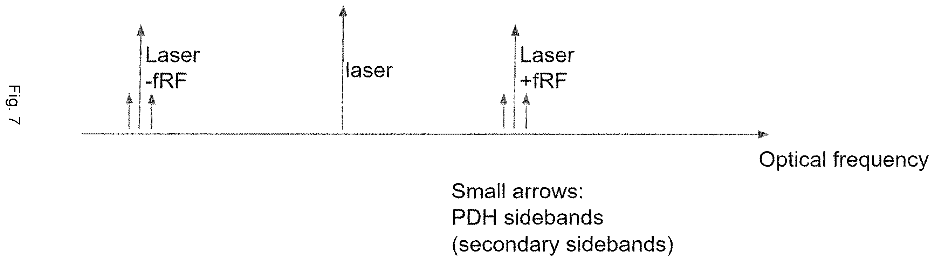

- Fig. 7: depicts a diagram of an optical frequency in master laser - cavity.

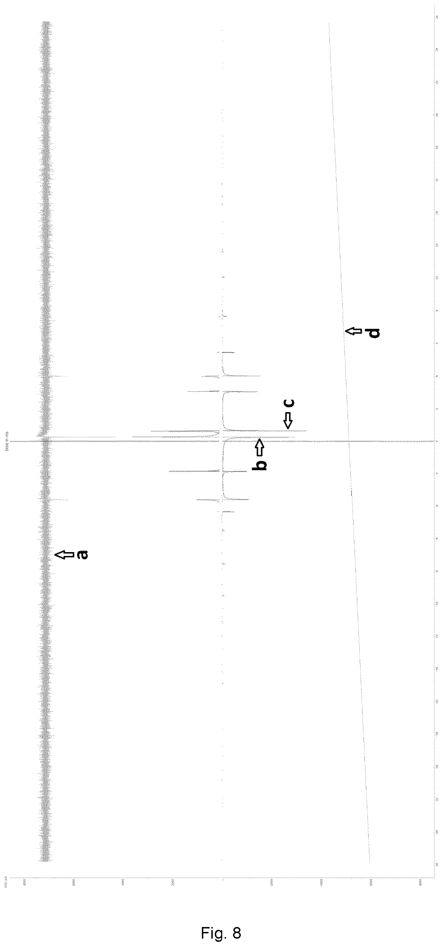

- Fig. 8: depicts a calibration plot showing the master laser photodiode signal ([a] line - light blue), the master laser PDH signal ([b] line - pink) and the slave laser PDH signal ([c] line - purple) in the cavity scan domain. ([d] line - orange is cavity piezoelectric voltage control).

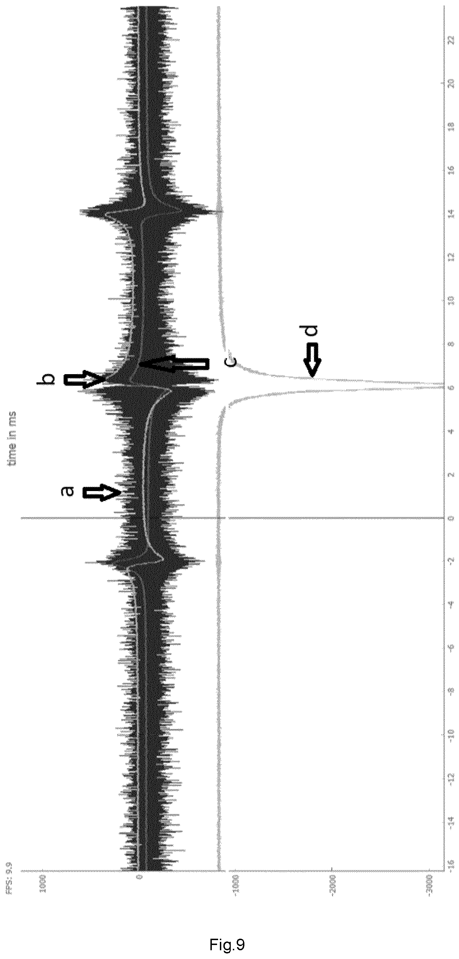

- Fig. 9: depicts a calibration plot showing the signal from the master laser photodiode (light blue - [d] line), the signal from the differential photodiode of the slave laser (dark blue - [a] line), and the two quadratures of the slave laser PDH signal (red [c] and orange [b] lines) in the cavity scan domain.

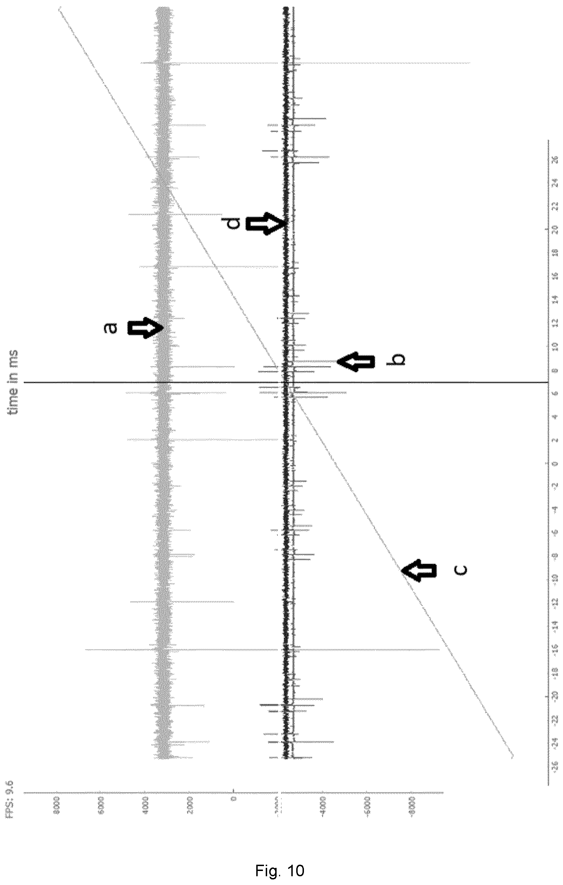

- Fig. 10: depicts a calibration plot showing the master laser photodiode signal ([a] line light blue) and the master laser PDH signal ([b] line - pink) in the cavity scan domain. ([c] line - orange is cavity piezoelectric voltage control, [d] line - blue is null signal) The figure uses notation that is consistent with the glossary definitions.

### Embodiments of the invention

The following example is included only to illustrate the invention and to explain particular aspects thereof, and not to limit it, and should not be interpreted as the entire range thereof which is defined in the appended patent claims. In the following embodiments, unless indicated otherwise, standard materials and methods used in the technical field were used or manufacturers' recommendations for specific devices, materials and methods were followed.

### EMBODIMENT OF THE INVENTION

### Description of the construction and operation method of the device according to the invention

The stabilisation system according to the invention comprises building blocks described divided (Fig. 1) into the following sections: (a) a master laser 10 (*i.e.* frequency reference - at about 50 MHz), whose frequency is stabilised to an external atomic reference 3 (rubidium vapours closed in vacuum).

General stabilisation device of the master laser 10 is depicted in Fig 1. A light beam 11 luminated from the master laser 10 goes through a fibre to a frequency shift and dithering modulator 12. Firstly, a small portion of light beam 19 is diverted at a sampling plate 54a to a reference light beam modulator 21, atomic reference 3, reference photodiode (detector) 20 and demodulator 4. Light diffracted in +1 order goes into atomic reference 3, which comprises a Rb (rubidium atomic) vapour cell and a photodiode 4, that is detector with demodulator (servo - electronic circuit providing stabilisation feedback for master laser 10). The electronic signal from photodiode 20 is analysed in electronic circuit comprising analog to digital (A-to-D) conversion of photodiode signal source for modulator 12, which has a predetermined frequency *e.g.* 66 MHz dithered by 100 kHz every 10 µs [microseconds] *i.e.* switched from 66.1 MHz to 55.9 MHz at a rate of 100 kHz. The photodiode 20 signal is demodulated synchronously with dithering at 4 (servo that is electronic circuit providing stabilisation feedback for the master laser 10) to detect the mismatch between atomic resonance of 3 and the master laser 10 frequency. At the output of the demodulator an electric error signal 31 is generated, which is integrated and fed back to master laser 10 frequency adjust input. At the activation procedure of the master laser 10 the above mentioned feedback loop is disconnected and instead the frequency of the master laser 10 is scanned 30 times per second for the full range of electronic tuning (about 1 GHz). The signal from the photodiode 20 is displayed on the oscilloscope revealing a fragment of the absorption spectrum of the atomic reference 3. A coarse tuning of the master laser 10 is activated if necessary and the desired atomic resonance is located. The master laser 10 is momentarily tuned to the atomic resonance 3 pointed by the user using a suitable control interface, scanning is turned off and the stabilisation loop is activated.

The cavity 100 has an adjustable length by at least two free spectral ranges (FSR) for the master laser 10. An example construction is depicted in Fig 2, where two high-reflectance concave mirrors 102 are facing one another at a distance (L1) of 60 mm inside an invar tube 101. Movable mirror 102 rests on a threaded insert 104 and a piezo stack 103 against which it is pressed by a threaded Teflon ring 105. The other mirror is fixed against a threaded brass ring 106 using threaded Teflon ring 107. The invar tube is slitted to let the piezo wires 108 through. Entire assembly of cavity 100 is placed in a vacuum. Two viton^{®} o-rings are stretched onto the invar tube and the cavity rests in a standard KF40 tee with laser beams entering through standard viewports. Fig. 2 also describes directions where light beams enter a cavity 100, namely light path of reference (master) laser enters cavity 100 via path 51 (left side of the cavity), wherein a light path of slave laser enters cavity 100 via light path 52 (right side of the cavity).

Reference light beam from the master laser 10 is transported towards the transfer cavity 100 using a single mode polarisation maintaining fibre 11. The light beam enters a fibre-optical phase modulator 12 which is driven by a frequency modulated tunable radio frequency signal 30. The signal 30 is a master laser frequency shift and PDH modulation signal, *i.e.* δ_{M} = 300-4000 MHz since phase modulated at 2-30 MHz. The carrier frequency of this signal is δ_{M} and will be added to and/or subtracted from the master laser 10 frequency. The sidebands due to frequency modulation, used for locking, occur at δ_{M}±δ_{MP}. The output of the modulator 12 exits the fibre into free space by means of a collimator 14 and through sampling plate 54b, polarising beam splitter 15 and quarter wave plate 16 enters the cavity 100. The light beam reflected from the cavity 100 goes back through the quarter wave plate 16 a second time and is reflected by the polarising beam splitter 15 towards photodiode 18 which converts the intensity of reflected light beam 51b into electrical signal 33 (slave frequency shift and PDH modulation signal).

Sampling plates 54a and 54b are inserted into the light beam pathway, sampling plate 54a is before modulator 12 and sampling plate 54b is placed in light pathway after modulator 12 and collimator 14. First, a small portion of light beam 19 is diverted at sampling plate 54a to photodiode 20 (detector), which converts the intensity of modulated light sent onto the cavity 100 into electrical master reference electrical signal 31. Normally, reference master reference intensity 31 is constant, especially the sidebands frequency δ_{MP}, but in some types of modulators 12 a parasitic amplitude modulation might appear. Its otherwise disruptive effects can be cancelled by measuring said amplitude modulation and subtracting it from signal property 32 at a later stage. Thus optionally, another (second) small portion of the modulated (in modulator 12) and collimated (in collimator 14) light beam is diverted at sampling plate 54b to a photodiode 22 (detector) and reference intensity of master laser (electric signal) 32 is directed to a first PDH servo for cavity stabilisation to master laser 10.

On the right side of Fig. 1, the light beam 61 emitted by a slave laser 60 enters the cavity 100 from the opposite side (right site of cavity 100 at Fig. 1) for convenience. A large portion light beam from slave laser 60 goes through a phase modulator 62 and enters the cavity 100 in a way analogous to that shown in Fig. 1 (left site) for master laser 10. A large portion of the beam from slave laser 60 goes through optical phase modulator 62 which is driven by a fixed frequency δ_{SP} signal 40, typically δ_{SP}=25 MHz. The modulator adds sidebands at ±δ_{SP}. The light beam from the modulator 62 goes through optional sampling plate 63, polarising beam splitter 65, quarter wave plate 66 and enters the cavity 100. The light reflected from the cavity 100 goes back through the quarter wave plate 66 for a second time and is reflected by the polarising beam splitter 65 towards photodiode 68 which converts the intensity of reflected light into electrical signal 72.

Some slave lasers 60 may be internally frequency modulated. For example a current of the diode lasers can be modulated to provide sidebands necessary for locking at little extra expense. In this case modulator 62 is not necessary. However, a parasitic amplitude modulation is introduced. This is compensated for using additional photodiode 70. Portion of modulated light 69 reflected by the sampling plate 63, is detected by the photodiode 70 and converted to electrical reference signal 71. If necessary, signal 71 is subtracted from 72 and the difference is fed to further circuitry in place of 72.

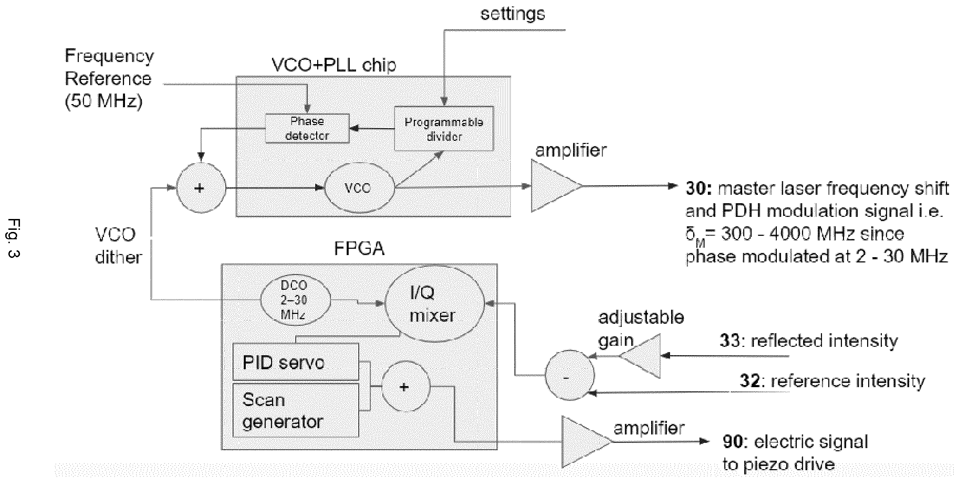

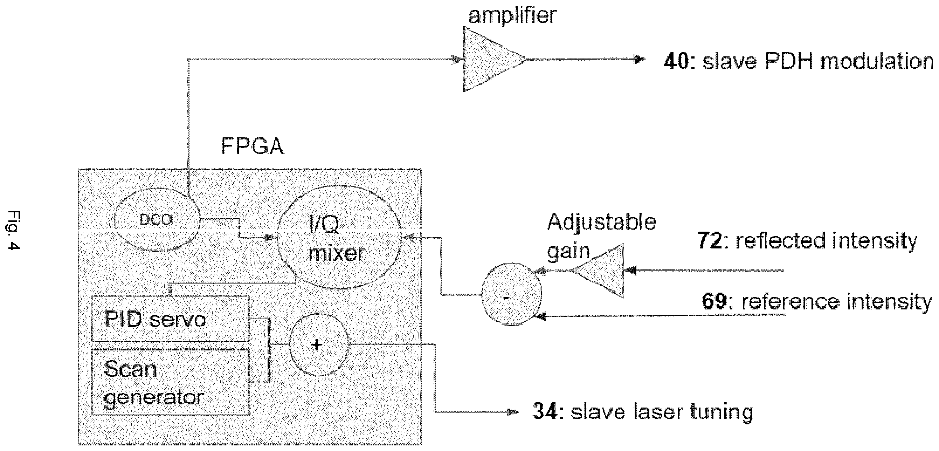

Block diagram of integrated controller (comprising both 6a and 6b) the cavity locking electronic system for master laser 10 and Pound-Drever-Hall (PDH) cavity lock, is depicted with details in Fig. 3 and Fig 4. It comprises an FPGA equipped with analog to digital (A-to-D) and digital to analog (D-to-A) converters (*e.g.* STEMlab 125-14) and a VCO+PLL (*e.g.* ADF4350). The VCO drives modulator 12 at δ_{M} in the range 300 - 4000 MHz with frequency dither at δ_{MP} = 62.5 MHz typically. Modulator 12 is driven by a digital output from an FPGA at a constant frequency of typically δ_{SP} = 25 MHz. Normally, this intensity is constant, especially the sidebands frequency δ_{MeP}, but for some types of modulators a parasitic amplitude modulation might appear. Its otherwise disruptive effects can be cancelled by measuring said amplitude modulation and subtracting it from electrical signal characteristic 32 at later stage. Electric signal 33 from master photodiode 18 (as well as the signal 72 from the slave photodiode 68) are demodulated at δ_{MP} and δ_{SP} respectively yielding error signals for master side (as well as from slave side). The master laser error signal 90 is used to correct the length of the cavity 100. It is electrically integrated and fed to the piezo 103 (see precise location of piezo on Fig. 2). The slave error signal drives the slave laser 60 through an integrated circuit (VCO+PLL), locking the frequency of the slave laser 60 to a resonance of the cavity 100.

At the startup, the cavity 100 is scanned 15 times per second with the maximum amplitude allowed by the piezo 103. Resonance for both the master laser 10 and the slave laser 60 can be observed as a function of cavity length.

Adjustment to master laser shift δ_{M} can be made to measure the FSR and thus the precise length of the cavity. By finding the lowest δ_{M} for which +1 and -1 sidebands of the master laser produced by modulator 12 are both simultaneously resonant with the cavity it is determined FSR = 2δ_{M} = c/2L where L is the cavity length at coincidence of peaks (Fig. 2 indicate length of cavity as L1). The PDH signals of +1 and -1 sidebands are exactly opposite, therefore their coincidence is marked by a vanishing PDH signal. Studied prototype of cavity 100 has length L1 of about 60 mm, FSR ~ 2500 MHz and decreases by about 32 kHz, when elongating the cavity by half the wavelength of reference laser (that wavelength is about 1560 nm). The cavity 100 finesse (F) is of about 5000 just enables determination of the exact order of resonance n = 2L/λ_{M}. In optimal condition a cavity 100 is characterised by a finesse (F) more than 200 for both lasers, master 10 and slave 60 laser respectively. The master laser 10 wavelength λ_{M} is known precisely because it is locked precisely to transition in Rubidium atomic vapour 3. In order to integrate resonances, completing this calibration step enables establishing the cavity 100 length with respect to absolute atomic reference 3. By following the resonances of the master laser 10 as they shift with changing δ_{M} a rough scaling of piezo voltage into master resonance frequencies can be easily established, in particular the precise range of cavity 100 lengths achievable by piezo adjustment L_{MIN} - L_{MAX} is found.

Given the exact frequency of the slave laser 60 it is calculated further steps for the stabilisation process. In the first step, it has to be known the exact length of cavity 100 that are resonant with desired slave laser 60 frequency and in the L_{MIN} - L_{MAX} range. Next, for each solution we calculate the master laser 10 frequency shift δ_{M} necessary to bring it to simultaneous resonance. One solution is chosen, typically close to the centre of length tuning and frequency tuning. The master laser 10 frequency shift δ_{M} is set electronically and the sideband is identified in the full cavity 100 length scan by the slope sign and its coarse position. Next, the slave laser 60 is adjusted by its coarse tuning means so that its resonance is close to said master resonance. The cavity 100 scanning is progressively made narrower around said master resonance. This is best achieved in successive steps to enable following piezo creep and drift. A frequency of a slave laser 60 can be corrected and piezo voltage momentarily adjusted to exact resonance in concurrence with closing stabilisation loops.

In summary, a frequency of the master laser 10 is locked to the atomic reference 3 of Rubidium vapours, next resonance of the cavity 100 is locked to the frequency of master laser 10, and then at the end frequency of slave laser 60 is locked to the cavity 100. This chain of frequency locking events is essential effect of the following invention described herewith.

### Operational procedure in an invented method:

a) locking master laser 10 with a sideband signal generated by passing an incoming laser beam emitted by a master laser 10 through the reference light beam modulator 21 to the atomic reference 3. Set master laser 10 frequency shift using VCO+PLL chip (integrated circuit) in a phase modulator 12, locking a sideband signal generated by passing an incoming laser beam emitted by a master laser 10 through the phase modulator 12 to the frequency reference 3;
b) adjusting an electronic sideband frequency relative to the locked master laser frequency by changing frequency shift with the phase modulator 12. Scanning cavity 100 and observing master laser 10 electronic sideband resonance in the cavity 100;
c) locking the cavity 100 to the master laser 10 electronic sideband shifted to the resonance of the cavity 100;
d) locking slave laser 60 to the resonance of the cavity 100 with a signal generated by passing an incoming laser beam emitted by a slave laser 60 through a phase modulator 62.

According to the invention, a feed-forward signal 80 is used between the first PDH servo 6a and the slave laser 60:
1. If the cavity modulation speed (piezo 103 bandwidth) is insufficient to stabilize the cavity 100 length, and the slave laser 60 can be modulated significantly faster than the cavity 100 itself, optional fast feed forward can be used to compensate the cavity length noise at high frequencies;
2. Sensitivity of the master PDH error signal has to be calibrated;
3. Sensitivity of the slave laser tuning signal has to be calibrated.

## Claims

1. A system for stabilising NIR-VIS laser to any frequency using cavity transfer lock to frequency shifted C-band stable laser, comprising:
a master laser (10), configured for emitting a master light beam towards a sampling plate (54a),
the sampling plate (54a) configured for splitting the master light beam into two light beam portions
and for directing a first portion (51a) of said master light beam through a sampling plate and a polarising beam splitter, PBS, (15) and a quarter-wave plate, QWP, (16) to an optical cavity (100), which optical cavity (100) is configured for directing the first portion of the master light beam reflected therefrom back through the quarter wave plate (16) and the polarising beam splitter (15) towards a photodiode (18), which photodiode (18) is configured for providing an electrical signal to a first Pound-Drever-Hall, PDH, servo (6a) for cavity (100) stabilisation to the master laser (10), wherein
the first PDH servo (6a) is electrically connected with the cavity (100) and
the cavity (100) is configured for receiving a slave light beam (52a) from a slave laser (60), through a polarising beam splitter, PBS, (65) and a quarter-wave plate, QWP, (66) and for directing the slave light beam reflected therefrom (52b) back through the quarter wave plate (66) and the polarising beam splitter (65) towards a photodiode (68), which photodiode (68) is configured for providing an electrical signal to a second PDH servo (6b) for slave laser (60) stabilisation to the cavity (100),
and for directing a second portion (19) of said master light beam via light pathway to frequency shift and dither subsystem, comprising a reference light beam modulator (21) and then through an atomic reference (3) to a reference photodiode (detector) (20) with demodulator (4), which is configured for providing a reference intensity electric signal (31) to the master laser (10)
wherein the system further comprises:
- a fibre (11) and a fibre electro-optical phase modulator (12) and is configured for providing the master laser beam through the fibre (11) to the phase modulator (12) and further to the sampling plate (54a) and
- a voltage-controlled oscillator, VCO, of phase-locked loop, PLL, which is dithered by PDH reference oscillator at frequency from 1 MHz to 100 MHz which imposes phase modulation for PDH scheme,
wherein the modulator (12) of master laser (10) is stabilised with at least 0.3 GHz to 4 GHz bandwidth
and wherein the first PDH servo (6a) is electrically connected (80) to the slave laser (60) in such a way as to provide electric fast feed forward signal of the first PDH servo (6a) to the slave laser (60), and wherein the slave laser is configured to be modulated significantly faster by the electric fast feed forward signal than the electrical signal for cavity stabilisation in order to compensate for cavity length noise at high frequencies.

2. The system according to claim 1, wherein the cavity (100) possesses a finesse F greater than 200 in respect for both the master laser (10) and the slave laser (60).

3. The system according to any one of claims 1 to 2, wherein the master laser (10) is a narrow linewidth laser, having the linewidth of less than 100 kHz, preferably a C-band laser, and having a long term frequency stabilised, preferably to atomic reference, preferably its second harmonic locked to Rubidium transition.

4. The system according to any one of claims 1 to 3, wherein the slave laser (60) is electronically tunable at least by 2 GHz within a minimum time of 1 ms.

5. The system according to claim 1, wherein the electronic signal for the optical modulator (12) is generated by a phase-locked loop together with a voltage controlled oscillator PLL+VCO, is an integrated circuit.

6. A method of stabilising a NIR-VIS laser to any frequency using cavity transfer lock to frequency shifted C-band stable laser, performed in a system defined by any one of claims 1 to 5, the method comprising the following actions:
(a) locking master laser (10) with a sideband signal generated by passing an incoming laser beam emitted by a master laser (10) through the reference light beam modulator (21) to the atomic reference (3);
(b) adjusting an electronic sideband frequency relative to the locked master laser frequency by changing frequency shift with the phase modulator (12) - scanning cavity (100) and observing master laser (10) electronic sideband resonance in the cavity (100);
(c) locking the cavity (100) to the master laser (10) electronic sideband shifted to the resonance of the cavity (100);
(d) locking slave laser (60) to the resonance of the cavity (100) with a signal generated by passing an incoming laser beam emitted by a slave laser (60) through a phase modulator (62)
wherein the first PDH servo (6a) is electrically connected (80) to the slave laser (60) in such a way as to provide electric fast feed forward signal of the first PDH servo (6a) to the slave laser (60) and wherein the slave laser is modulated significantly faster by the electric fast feed forward signal than the electrical signal for cavity stabilisation in order to compensate for cavity length noise at high frequencies.

7. The method according to claim 6, wherein the first PDH servo (6a) stabilises the optical cavity (100) in order to control +1 or -1 electronic sideband of the master laser (10) generated by the optical modulator (12).

8. The method according to claim 6 or 7, wherein the light beam from the master laser (10) is directed via a light pathway into the fibre (11) and the phase modulator (12) that is driven by a frequency modulated tunable radio frequency signal (30) from the first PDH servo (6a) and then the light beam is directed by a light pathway to a collimator (14) and through the sampling plates (54a, 54b), the polarising beam splitter (15) and the quarter wave plate (16) enters the optical cavity (100).

9. The method according to claim 6, 7 or 8, wherein the part of the master laser beam reflected from the optical cavity (100) goes through the quarter wave plate (16) a second time and is reflected by the polarising beam splitter (15) towards the photodiode (18), which converts the intensity of reflected light into electrical signal (32).

10. The method according to any one of claims 6 to 9, wherein the length of the optical cavity (100) is adjusted electronically by at least 2 wavelengths of the master laser (10) by means of a piezo transducer (103) or other means, such as thermal control of an invar body of the cavity.

11. A computer program, wherein it contains instructions which implement the above method and includes instructions which, once uploaded to the integrated circuit of the phase-locked loop and voltage controlled oscillator module, implements the method defined in claims 6-10.

## Patentansprüche

1. System zum Stabilisieren eines NIR/VIS-Lasers auf eine beliebige Frequenz unter Verwendung eines Resonator-Transferlocks zu einem frequenzverschobenen stabilen C-Band-Laser, umfassend:
einen Master-Laser (10), der zum Emittieren eines Master-Lichtstrahls in Richtung einer Probenahmeplatte (54a) konfiguriert ist,
wobei die Probenahmeplatte (54a) zum Aufteilen des Master-Lichtstrahls in zwei Lichtstrahlabschnitte und zum Leiten eines ersten Abschnitts (51a) des Master-Lichtstrahls durch eine Probenahmeplatte und einen polarisierenden Strahlteiler, PBS, (15) und eine Viertelwellenplatte, QWP, (16) zu einem optischen Resonator (100) konfiguriert ist, wobei der optische Resonator (100) zum Leiten des des davon reflektierten ersten Abschnitts des Master-Lichtstrahls zurück durch die Viertelwellenplatte (16) und den polarisierenden Strahlteiler (15) zu einer Fotodiode (18) konfiguriert ist, wobei die Fotodiode (18) zum Bereitstellen eines elektrischen Signals an einen ersten Pound-Drever-Hall, PDH, - Servomotor (6a) zur Stabilisierung des Resonators (100) zum Master-Laser (10) konfiguriert ist, wobei
der erste PDH-Servomotor (6a) elektrisch mit dem Resonator (100) verbunden ist und
der Resonator (100) zum Empfangen eines Slave-Lichtstrahls (52a) von einem Slave-Laser (60) durch einen polarisierenden Strahlteiler, PBS, (65) und eine Viertelwellenplatte, QWP, (66) und zum Leiten des davon reflektierten Slave-Lichtstrahls (52b) zurück durch die Viertelwellenplatte (66) und den polarisierenden Strahlteiler (65) zu einer Fotodiode (68) konfiguriert ist, wobei die Fotodiode (68) zum Bereitstellen eines elektrischen Signals an einen zweiten PDH-Servomotor (6b) zur Stabilisierung des Slave-Lasers (60) zum Resonator (100) konfiguriert ist,
und zum Leiten eines zweiten Abschnitts (19) des Master-Lichtstrahls über einen Lichtweg zu einem Subsystem für Frequenzverschiebung und -Dithering, das einen Referenzlichtstrahlmodulator (21) umfasst, und dann durch eine atomare Referenz (3) zu einer Referenzfotodiode (Detektor) (20) mit Demodulator (4) konfiguriert ist, die zum Bereitstellen eines elektrischen Referenzintensitätssignals (31) für den Master-Laser (10) konfiguriert ist,
wobei das System ferner Folgendes umfasst:
- eine Faser (11) und einen elektrooptischen Phasenmodulator (12), der zum Bereitstellen des Master-Laserstrahls durch die Faser (11) zum Phasenmodulator (12) und weiter zur Probenahmeplatte (54a) konfiguriert ist, und
- einen spannungsgesteuerten Oszillator, VCO, einer Phasenregelschleife, PLL, der durch einen PDH-Referenzoszillator mit einer Frequenz von 1 MHz bis 100 MHz gedithert wird, der eine Phasenmodulation für das PDH-Schema auferlegt, wobei der Modulator (12) des Master-Lasers (10) mit einer Bandbreite von mindestens 0,3 GHz bis 4 GHz stabilisiert ist,
und wobei der erste PDH-Servomotor (6a) elektrisch mit dem Slave-Laser (60) derart verbunden (80) ist, dass dem Slave-Laser (60) ein elektrisches schnelles Vorsteuersignal des ersten PDH-Servomotors (6a) bereitgestellt wird, und wobei der Slave-Laser konfiguriert ist, um durch das elektrische schnelle Vorsteuersignal deutlich schneller moduliert zu werden als durch das elektrische Signal zur Resonatorstabilisierung, um das Resonator-Längenrauschen bei hohen Frequenzen zu kompensieren.

2. System nach Anspruch 1, wobei der Resonator (100) sowohl in Bezug auf den Master-Laser (10) als auch in Bezug auf den Slave-Laser (60) eine Finesse F von mehr als 200 aufweist.

3. System nach irgendeinem der Ansprüche 1 bis 2, wobei der Master-Laser (10) ein schmalbandiger Laser mit einer Linienbreite von weniger als 100 kHz ist, vorzugsweise ein C-Band-Laser, und eine langfristige Frequenz aufweist, die stabilisiert ist, vorzugsweise zu einer atomaren Referenz, vorzugsweise deren zweite Harmonische zum Rubidium-Übergang fixiert ist.

4. System nach irgendeinem der Ansprüche 1 bis 3, wobei der Slave-Laser (60) innerhalb einer Mindestzeit von 1 ms elektronisch um mindestens 2 GHz abstimmbar ist.

5. System nach Anspruch 1, wobei das elektronische Signal für den optischen Modulator (12) durch eine Phasenregelschleife zusammen mit einem spannungsgesteuerten Oszillator PLL+VCO erzeugt wird, der eine integrierte Schaltung ist.

6. Verfahren zum Stabilisieren eines NIR/VIS-Lasers auf eine beliebige Frequenz unter Verwendung eines Resonator-Transferlocks zu einem frequenzverschobenen stabilen C-Band-Laser, das in einem durch irgendeinen der Ansprüche 1 bis 5 definierten System durchgeführt wird, wobei das Verfahren die folgenden Aktionen umfasst:
(a) Fixieren des Master-Lasers (10) mit einem Seitenbandsignal, das erzeugt wird, indem ein von einem Master-Laser (10) emittierter einfallender Laserstrahl durch den Referenzlichtstrahlmodulator (21) zur atomaren Referenz (3) hindurchgeleitet wird;
(b) Anpassen einer elektronischen Seitenbandfrequenz relativ zur fixierten Master-Laser-Frequenz, indem die Frequenzverschiebung mit dem Phasenmodulator (12) durch Abtasten des Resonators (100) und Beobachten der elektronischen Seitenbandresonanz des Master-Lasers (10) im Resonator (100) geändert wird;
(c) Fixieren des Resonators (100) zum elektronischen Seitenband des Master-Lasers (10), das zur Resonanz des Resonators (100) verschoben ist;
(d) Fixieren des Slave-Lasers (60) zur Resonanz des Resonators (100) mit einem Signal, das erzeugt wird, indem ein von einem Slave-Laser (60) emittierter einfallender Laserstrahl durch einen Phasenmodulator (62) hindurchgeleitet wird,
wobei der erste PDH-Servomotor (6a) elektrisch (80) mit dem Slave-Laser (60) derart verbunden ist, dass dem Slave-Laser (60) ein elektrisches schnelles Vorsteuersignal des ersten PDH-Servomotors (6a) bereitgestellt wird, und wobei der Slave-Laser durch das elektrische schnelle Vorsteuersignal deutlich schneller moduliert wird als durch das elektrische Signal zur Resonatorstabilisierung, um das Resonator-Längenrauschen bei hohen Frequenzen zu kompensieren.

7. Verfahren nach Anspruch 6, wobei der erste PDH-Servomotor (6a) den optischen Resonator (100) stabilisiert, um das +1- oder -1-elektronische Seitenband des Master-Lasers (10) zu steuern, das durch den optischen Modulator (12) erzeugt wird.

8. Verfahren nach Anspruch 6 oder 7, wobei der Lichtstrahl vom Master-Laser (10) über einen Lichtweg in die Faser (11) und den Phasenmodulator (12) geleitet wird, der durch ein frequenzmoduliertes abstimmbares Hochfrequenzsignal (30) vom ersten PDH-Servomotor (6a) angesteuert wird, und dann der Lichtstrahl über einen Lichtweg zu einem Kollimator (14) und durch die Probenahmeplatten (54a, 54b), den polarisierenden Strahlteiler (15) und die Viertelwellenplatte (16) in den optischen Resonator (100) eintritt.

9. Verfahren nach Anspruch 6, 7 oder 8, wobei der Teil des Master-Laserstrahls, der vom optischen Resonator (100) reflektiert wird, ein zweites Mal durch die Viertelwellenplatte (16) hindurchgeht und vom polarisierenden Strahlteiler (15) zur Fotodiode (18) reflektiert wird, die die Intensität des reflektierten Lichts in ein elektrisches Signal (32) umwandelt.

10. Verfahren nach irgendeinem der Ansprüche 6 bis 9, wobei die Länge des optischen Resonators (100) elektronisch um mindestens 2 Wellenlängen des Master-Lasers (10) mithilfe eines Piezo-Wandlers (103) oder anderer Mittel, wie z. B. der thermischen Steuerung eines Invar-Körpers des Resonators, angepasst wird.

11. Computerprogramm, das Anweisungen enthält, die das obige Verfahren implementieren, und Anweisungen einschließt, die, sobald sie in die integrierte Schaltung des Moduls aus Phasenregelschleife und spannungsgesteuertem Oszillator hochgeladen sind, das in den Ansprüchen 6-10 definierte Verfahren implementieren.

## Revendications

1. Système permettant de stabiliser un laser NIR-VIS à n'importe quelle fréquence en utilisant un verrouillage par transfert de cavité sur un laser stable en bande C décalé en fréquence :
un laser maître (10), configuré pour émettre un faisceau lumineux maître vers une plaque d'échantillonnage (54a),
la plaque d'échantillonnage (54a) configurée pour diviser le faisceau lumineux maître en deux parties de faisceau lumineux
et pour diriger une première partie (51a) dudit faisceau lumineux maître à travers une plaque d'échantillonnage et un séparateur de faisceau polarisant, PBS, (15) et une plaque quart d'onde, QWP, (16) vers une cavité optique (100), cette cavité optique (100) est configurée pour diriger la première partie du faisceau de lumière maître qui y est réfléchie vers une photodiode (18) à travers la lame quart d'onde (16) et le séparateur de faisceau polarisant (15), cette photodiode (18) étant configurée pour fournir un signal électrique à un premier servo PDH Pound-Drever-Hall (6a) pour la stabilisation de la cavité (100) vers le laser maître (10), dans lequel
le premier servo PDH (6a) est connecté électriquement à la cavité (100) et
la cavité (100) est configurée pour recevoir un faisceau lumineux esclave (52a) provenant d'un laser esclave (60), à travers un séparateur de faisceau polarisant (PBS) (65) et une lame quart d'onde (QWP, (66) et pour diriger le faisceau lumineux esclave réfléchi (52b) à travers la lame quart d'onde (66) et le séparateur de faisceau polarisant (65) vers une photodiode (68), laquelle photodiode (68) est configurée pour fournir un signal électrique à un second servo PDH (6b) pour la stabilisation du laser esclave (60) dans la cavité (100),
et pour diriger une deuxième partie (19) dudit faisceau lumineux maître par un trajet optique vers un sous-système de décalage de fréquence et de dither, comprenant un modulateur de faisceau lumineux de référence (21), puis à travers une référence atomique (3) vers une photodiode de référence (détecteur) (20) avec démodulateur (4), qui est configurée pour fournir un signal électrique d'intensité de référence (31) au laser maître (10)
dans lequel le système comprend en outre:
- une fibre (11) et un modulateur de phase électro-optique à fibre (12) et est configuré pour fournir le faisceau laser maître à travers la fibre (11) au modulateur de phase (12) et ensuite à la plaque d'échantillonnage (54a) et
- un oscillateur commandé en tension, VCO, d'une boucle à verrouillage de phase, PLL, qui est désynchronisé par l'oscillateur de référence PDH à une fréquence de 1 MHz à 100 MHz qui impose une modulation de phase pour le schéma PDH, dans lequel le modulateur (12) du laser maître (10) est stabilisé avec une largeur de bande d'au moins 0,3 GHz à 4 GHz
et dans lequel le premier servo PDH (6a) est connecté électriquement (80) au laser esclave (60) de manière à fournir un signal électrique d'avance rapide du premier servo PDH (6a) au laser esclave (60), et dans lequel le laser esclave est configuré pour être modulé beaucoup plus rapidement par le signal électrique d'avance rapide que par le signal électrique de stabilisation de la cavité afin de compenser le bruit de longueur de la cavité à des fréquences élevées.

2. Le système selon la revendication 1, dans lequel la cavité (100) possède une finesse F supérieure à 200 pour le laser maître (10) et le laser esclave (60).

3. Le système selon l'une des revendications 1 à 2, dans lequel le laser maître (10) est un laser à largeur de raie étroite, ayant une largeur de raie inférieure à 100 kHz, de préférence un laser à bande C, et ayant une fréquence stabilisée à long terme, de préférence à une référence atomique, de préférence sa deuxième harmonique verrouillée sur la transition du rubidium.

4. Le système selon l'une des revendications 1 à 3, dans lequel le laser esclave (60) est accordable électroniquement au moins à 2 GHz dans un temps minimum de 1 ms.

5. Le système selon la revendication 1 dans lequel le signal électronique pour le modulateur optique (12) est généré par une boucle à verrouillage de phase avec un oscillateur commandé en tension PLL+VCO, est un circuit intégré.

6. Méthode de stabilisation d'un laser NIR-VIS à n'importe quelle fréquence à l'aide d'un verrouillage par transfert de cavité sur un laser stable en bande C décalé en fréquence, exécutée dans un système défini par l'une des revendications 1 à 5, la méthode comprenant les actions suivantes :
(a) verrouillage du laser maître (10) avec un signal de bande latérale généré en faisant passer un faisceau laser entrant émis par un laser maître (10) à travers le modulateur de faisceau lumineux de référence (21) vers la référence atomique (3) ;
(b) réglage d'une fréquence de bande latérale électronique par rapport à la fréquence du laser maître verrouillé en modifiant le décalage de fréquence avec le modulateur de phase (12) - cavité de balayage (100) et observation de la résonance de la bande latérale électronique du laser maître (10) dans la cavité (100) ;
(c) verrouillage de la cavité (100) sur la bande latérale électronique du laser maître (10) décalée sur la résonance de la cavité (100) ;
(d) verrouillage du laser esclave (60) à la résonance de la cavité (100) à l'aide d'un signal généré par le passage d'un faisceau laser entrant émis par un laser esclave (60) à travers un modulateur de phase (62)
dans lequel le premier servo PDH (6a) est connecté électriquement (80) au laser esclave (60) de manière à fournir un signal électrique d'avance rapide du premier servo PDH (6a) au laser esclave (60) et dans lequel le laser esclave est modulé beaucoup plus rapidement par le signal électrique d'avance rapide que par le signal électrique de stabilisation de la cavité afin de compenser le bruit de longueur de la cavité à des fréquences élevées.

7. Procédé selon la revendication 6, dans lequel le premier servo PDH (6a) stabilise la cavité optique (100) afin de contrôler +1 ou -1 bande latérale électronique du laser maître (10) généré par le modulateur optique (12).

8. Procédé selon la revendication 6 ou 7, dans lequel le faisceau lumineux du laser maître (10) est dirigé par une voie lumineuse dans la fibre (11) et le modulateur de phase (12) qui est commandé par un signal radiofréquence accordable modulé en fréquence (30) provenant du premier servo PDH (6a), puis le faisceau lumineux est dirigé par une voie lumineuse vers un collimateur (14) et, à travers les plaques d'échantillonnage (54a, 54b), le séparateur de faisceau polarisant (15) et la plaque quart d'onde (16), il pénètre dans la cavité optique (100).

9. Procédé selon la revendication 6, 7 ou 8, dans lequel la partie du faisceau laser maître réfléchie par la cavité optique (100) traverse une seconde fois la lame quart d'onde (16) et est réfléchie par le séparateur de faisceau polarisant (15) vers la photodiode (18), qui convertit l'intensité de la lumière réfléchie en signal électrique (32).

10. Méthode selon l'une des revendications 6 à 9, 2 dans laquelle la longueur de la cavité optique (100) est ajustée électroniquement par au moins deux longueurs d'onde du laser maître (10) au moyen d'un transducteur piézoélectrique (103) ou d'autres moyens, tels que le contrôle thermique d'un corps invariant de la cavité.

11. Programme d'ordinateur, contenant des instructions qui mettent en oeuvre la méthode ci-dessus et comprenant des instructions qui, une fois chargées dans le circuit intégré du module de boucle à verrouillage de phase et d'oscillateur commandé en tension, mettent en oeuvre la méthode définie dans les revendications 6 à 10.
